# EUROPEAN PATENT APPLICATION

(11) **EP 1 215 302 A1**
(43) Date of publication of application: **19.06.2002**
(21) Application number: 00944303.7
(22) Date of filing: 06.07.2000
(51) Int. Cl.: C23C 14/35

(54) **SPUTTERING DEVICE AND FILM FORMING METHOD**

(30) Priority: 06.07.1999 JP 19170299
(71) Applicant: APPLIED MATERIALS, INC., Santa Clara, California 95054-3299 (US)
(72) Inventor: Aida, Hisashi, Narita-shi, Chiba 286-8516 (JP); Tsuneoka, Masatoshi, Narita-shi, Chiba 286-8516 (JP)
(74) Representative: Draper, Martyn John
(86) International application number: JP0004511
(87) International publication number: WO0102619

(57) **Abstract**

A sputtering apparatus comprises: a vacuum chamber; a pedestal for supporting a substrate in the vacuum chamber; a target positioned so that the erosion surface faces the substrate, which is supported by the pedestal; a gas supplying means for supplying process gas into the vacuum chamber; a depressurizing means for depressurizing the vacuum chamber; and a magnetron unit disposed on the side opposite to the erosion surface. The magnetron unit comprises subunits that generate magnetic fields along the reference axis, which runs from the erosion surface to a surface of the substrate. The ionization of sputtering particles by the magnetic field is facilitated, causing stable self-sputtering to occur.

## Description

### Technical Field

The present invention relates to a sputtering apparatus and a film forming method or film deposition method using the sputtering apparatus.

### Background Art

Based on improvements in the integration and further miniaturization of the interconnective pattern of the semiconductor device in recent years, it has become difficult use sputtering methods to efficiently form interconnective films in contact holes and via holes and the like.

In cases where film deposition is carried out on the surface of semiconductor wafers having the above microscopic holes with a typical magnetron sputtering apparatus, problems develop such as overhangs at the entrance portion of the holes and decreases in the bottom-coverage ratio.

Techniques for a collimation sputtering method and a remote sputtering method and the like have been developed to solve these problems. In addition, a self-sputtering method has advantages that are not found in the collimation sputtering method and remote sputtering method, and is a promising future technique for solving such problems.

The self-sputtering phenomenon is a phenomenon where particles, which are used for making a target sputter, are sputtered by particles, which have been sputtered from the target. In order to utilize this phenomenon in film deposition, argon is first introduced as a process gas to generate sputtering particles. After the transition into a self-sputtering state, it is necessary to stop the supply of process gas, and have the sputtering process progress by self-sputtering alone.

However, there are portions of the generating mechanism of self-sputtering that have not been resolved, and thus stabilizing and controlling self-sputtering is left as a challenge.

Accordingly, the present invention aims to provide a sputtering apparatus, wherewith it is possible to generate an appropriate magnetic field in order to stably induce self-sputtering.

### Disclosure of the Invention

The inventors have carried out various trial and error processes in order to apply self-sputtering to film deposition technology. As a result, the inventors have arrived at the following findings.

Designs of conventional sputtering apparatus were carried out so as to strengthen the magnetic field components parallel to the sputtering surface of the target. However, to make the generating of self-sputtering easier, it is necessary to make the magnetic field components that run in a vertical direction to the target surface become stronger than the magnetic field components that are in the horizontal direction.

On the other hand, if the magnetic field components in the vertical direction that make the generating of self-sputtering easier are made to be stronger, it becomes difficult to decrease the argon discharge voltage. As a result, it is understood that there are cases where the generation of plasma, which is necessary to sustain sputtering, may cease during the transition into self-sputtering.

In order to solve such problems, the inventors accordingly came to the conclusion that it is necessary to appropriately generate and control the magnetic field for sputtering. To this end, the present invention is given the following structure.

The sputtering apparatus according to the present invention comprises (1) a vacuum chamber, (2) depressurizing means for depressurizing the chamber, (3) gas supplying means for supplying process gas into the vacuum chamber, (4) a substrate-supporting portion, (5) a sputtering target, and (6) a magnetron unit.

In this kind of sputtering apparatus, the substrate-supporting portion is mounted in the vacuum chamber to support the substrate. The sputtering target is positioned so that the erosion surface faces the substrate-supportingportion. The magnetron unit is disposed on the opposite side of the target from the substrate-supporting portion. The magnetron unit includes a plurality of subunits.

Such configuration of a magnetron unit as presented in the following is preferable since the particles sputtered from the sputtering target cause the sputtering target to sputter.

In the sputtering apparatus according to the present invention, a first magnet part has a first magnet, wherein this first magnet is disposed so the one end indicating a first magnetic polarity faces the target. A second magnet part has a second magnet, wherein this second magnet is disposed so the one end indicating a second magnetic pole faces the target. Each subunit may include a first magnetic member for supporting the first and second magnets. The first and second magnets configure a magnetic circuit with the first magnetic member therebetween.

In addition, in the sputtering apparatus according to the present invention, the first magnet part may comprise a third magnet and a second magnetic member. The third magnet is disposed so that it is adjoined to the first magnet with the one end indicating the first magnetic polarity facing the target. The second magnetic member supports the third magnet.

In this kind of magnetron unit, each of the plurality of subunits has a first magnet part and a second magnet part. The first magnet part has a larger magnetic charge than the second magnet part. Therefore, a portion of the magnetic flux from the first magnet part reaches the second magnet part. The magnetic field based on this magnetic flux mainly has magnetic field components in the vicinity of the erosion surface of the target, which are parallel to this erosion surface. On the other hand, a magnetic field based on the remaining portion of the above-mentioned magnetic flux mainly has magnetic field components that run perpendicular to the erosion surface.

Moreover, in the sputtering apparatus according to the present invention, each of the plurality of subunits include a first magnet, a second magnet, a first magnetic member, a fourth magnet, a fifth magnet, and a third magnetic member.

The first magnet is disposed with the one end indicating a first magnetic polarity facing the target. The second magnet is disposed with the one end indicating a second magnetic polarity facing the target. The first and second magnets are supported by the first magnetic member, and structure a magnetic circuit with this first magnetic member therebetween. The fourth magnet is positioned so that it is adjoined to the first magnet, which is disposed with the one end indicating the first magnetic polarity facing the target. The fifth magnet is provided with the one end indicating a second magnetic polarity facing the target. The fourth and fifth magnets are supported by the third magnetic member, and structure a magnetic circuit with this third magnetic member therebetween. It is noted here that the fifth magnet may be positioned on the opposite side of the first magnet than the fourth magnet.

The magnetic flux that is associated with one end of the first magnet reaches one end of the second magnet. Also, the magnetic flux that is associated with one end of the fourth magnet reaches one end of the fifth magnet. This magnetic flux extends in a direction parallel to this erosion surface in the vicinity of the erosion surface of the target. Therefore, a magnetic field based on this magnetic flux mainly has magnetic field components that run parallel to the erosion surface. One end of the first and the fourth magnets respectively indicate the same magnetic polarity and are positioned adjoining each other.
Therefore, the magnetic flux from the respective adjoining parts of these magnets extends in a direction perpendicular to the erosion surface while mutually affecting each other. The magnetic field based on this magnetic flux mainly has magnetic field components perpendicular to the erosion surface.

Moreover, in the sputtering apparatus according to the present invention, each of the plurality of subunits has a sixth magnet, a seventh magnet, a fourth magnetic member that supports the sixth and seventh magnets, as well as a fifth magnetic member.

The sixth magnet has one end that indicates a first magnetic polarity and another end that indicates a second magnetic polarity, and is disposed with the one end facing the target. The seventh magnet is disposed with the one end indicating a second magnetic polarity facing the target.

The fifth magnetic member is positioned so that one end and another end of the sixth magnet are magnetically joined. Therefore, a portion of the magnetic flux from the one end of the sixth magnet reaches that other end passing through the fifth magnetic member without passing through the vacuum chamber. A magnetic field based on the remaining portion of the above-mentioned magnetic flux reaches one end of the seventh magnet. In the vicinity of the erosion surface of the target, the magnetic field based on this magnetic flux mainly has magnetic field components running parallel to this erosion surface. On the other hand, the magnetic field based on the remaining magnetic flux associated with one end of the seventh magnet mainly has magnetic field components running perpendicular to the erosion surface.

Process gas is transformed into plasma in the vicinity of the erosion surface by the magnetron unit in such sputtering apparatus. With this plasma, target particles are sputtered from the erosion surface. Respective subunits generate a magnetic field, which has magnetic field components running in the direction perpendicular to the erosion surface that are greater than the magnetic field components running in the direction horizontal thereto, in a region differing from the vicinity of the erosion surface. The sputtered particles are efficiently ionized in the region within the vacuum chamber where the vertical components of the magnetic field are dominant over the horizontal components. The ionized particles are accelerated towards the erosion surface, and accordingly other sputtering particles are generated when they collide with the erosion surface. Hence, self-sputtering successively occurs.

In the magnetron unit according to the present invention, a plurality of subunits is positioned running in the direction that the erosion surface extends. The magnetron unit has the following characteristics regarding a first and a second region that are positioned in order along the axial from the erosion surface towards the substrate-supporting portion. In the first region, the magnetic field components running in a direction parallel to the erosion surface are larger than those running in the direction perpendicular to the erosion surface. In the second region, the magnetic field components running in the direction perpendicular to the erosion surface are larger than those running in the direction parallel to the erosion surface.

In the sputtering apparatus according to the present invention, the sputtering target may include at least one of copper, palladium or gold. The self-sputtering phenomenon easily occurs with the use of these elements.

In the sputtering apparatus according to the present invention, a controlling means for reducing the amount of process gas supplied after plasma generation may also be provided. As a result, the transition into self-sputtering becomes possible.

In addition, in the sputtering apparatus according to the present invention, a controlling means for stopping the supply of process gas during film deposition through sputtering may also be provided. As a result, the self-sputtering particles that are transferred from the space where process gas does not exist are passed on to the substrate.

In the sputtering apparatus according to the present invention, a gas supplying means, and a control unit for controlling the operation of the magnetron unit may also be provided. If the control unit is provided, it is possible to mutually associate the operations of the gas supplying means and the magnetron unit to control them. As a result, it is possible to precisely set the conditions for efficiently generating self-sputtering and the conditions for making a smooth transition into self-sputtering.

The film deposition method according to the present invention relates to a method of forming film using sputtered particles from the target by the sputtered particles that have been sputtered from the target provided in the vacuum chamber, and comprises the following steps. This method comprises (1) a step of preparing a magnetron unit that generates a magnetic field with magnetic field components running in the direction orthogonal to the reference axis, which connects the target and the substrate-supporting portion, that are larger than the magnetic field components running in the direction along the reference axis in a region in the vicinity of the erosion surface, and generates a magnetic field with magnetic field components running in the direction along the reference axis that are greater than the magnetic field components that run in the direction orthogonal to the reference axis in the region between the target and the substrate; (2) a step of configuring the substrate, which has a surface on which film is to be deposited, in the vacuum chamber; (3) a step of supplying process gas into the vacuum chamber; (4) a step of forming plasma from process gas in the vicinity of the erosion surface causing sputtered particles to generate from the target; and (5) a step of depositing film on a substrate by accumulating sputtered particles from the target under the condition where the supply of process gas is stopped.

When the plasma of process gas is formed in the vicinity of the erosion surface in this manner, particles sputtered from the erosion surface are generated. When the magnetic field that runs along the reference axis connecting the erosion surface and the substrate-supporting portion generates in the region between the target and the substrate, the particles sputtered from the target are ionized. When the ionized particles reach the erosion surface, other particles are then generated through sputtering. Self-sputtering successively progresses in this manner even if the supply of process gas is stopped. A portion of the particles that is self-sputtered from the target progress along the above-mentioned reference axis. When they reach the surface of the substrate on which film deposition is to be performed, the sputtered particles sequentially accumulate on the surface of the substrate.

According to a different aspect of the present invention, the sputtering apparatus is characterized by comprising a sputtering target configured in the chamber; a depressurizing means for depressurizing inside the chamber; a gas supplying means for supplying process gas into the chamber; a plasma-generating means for transforming the process gas supplied to the chamber into a plasma state by applying a voltage to the sputtering target; and a magnetron unit disposed along the sputtering target; wherein the magnetron unit is comprised of first magnet parts with a first polarity, which are annularly arranged; and second magnet parts, which have a second polarity differing from the first polarity and a gross magnetic charge that is greater than the gross magnetic charge of this first magnet parts and which are circularly disposed so as to surround the first magnet parts; and the gas supplying means for reducing the amount of process gas to be supplied into the chamber after the process gas is transformed into the plasma state.

The second magnet parts having a gross magnetic charge that is greater than the gross magnetic charge of the first magnet parts are disposed around the first magnet parts. As a result, a portion of the magnetic lines of force that are emitted from the second magnet parts forms a closed-loop, magnetic circuit between the first and second magnet parts, and the remainder are in the state of extending toward the side of the wafer placed opposite to the sputtering target. The magnetic lines of force that extend towards this wafer side are in the state of existing between the generated plasma and the chamber-side wall, thus the phenomenon wherein among the high energy electrons (secondary electrons) emitted from the sputtering target by sputtering, the electrons collected in the magnetic field that appear on the erosion surface, for example flow out to the side of the reference potential member where a shield member and the like are provided on the side of the chamber side wall, and can function so that the electrons can be effectively confined in the neighboring region of the sputtering target.

Furthermore, by making the gross magnetic charge of the second magnet parts, which are positioned on the outer side in relation to the first magnet parts, larger than the gross magnetic charge of the first magnet parts, magnetic lines of force are formed extending from the sputtering target to the wafer side, and these magnetic lines of force function so that the electrons leave the sputtering particles that run towards the wafer side, facilitating the ionization of the sputtering particles. The ionized sputtering particles then change their kinetic direction so as to head towards the sputtering target through the influence of an electric field, which is formed by applying voltage to the sputtering target, then are accelerated, colliding into the sputtering target. The sputtering target is sputtered using the energy at the time of this collision, to become the so-called state of self-sputtering.

When self-sputtering begins to occur, normal sputtering due to the transformation of process gas into plasma and self-sputtering co-exist (the transition state). From this state, normal sputtering due to the transformation of process gas into plasma has a tendency to decrease when the gas supplying means decreases the amount of process gas supplied to the chamber. At this time, ionization of the sputtering particles is facilitated and self-sputtering can be more effectively sustained through the function of the magnetic lines of force formed extending from the sputtered target to the wafer side.

Yet another aspect of the present invention is directed to a film deposition method. The sputtering apparatus used in this film deposition method comprises a sputtering target configured in a chamber; depressurizing means for depressurizing inside the chamber; gas supplying means for supplying process gas into the chamber; plasma-transforming means for transforming the process gas supplied into the chamber into a plasma state by applying a voltage to the sputtering target; and a magnetron unit disposed along the sputtering target; and the magnetron unit comprises first magnet parts with a first polarity, which are annularly arranged, and second magnet parts, which have a second polarity differing from the first polarity as well as a gross magnetic charge that is greater than the gross magnetic charge of these first magnet parts and which are positioned around said first magnet parts. This film deposition method is characterized by comprising a first step of supplying process gas into the chamber under a depressurized atmosphere, as well as scattering the sputtering particles from the sputtering target as the process gas in the plasma state; and a second step of reducing the amount of process gas supplied into the chamber after the process gas is transformed into the plasma state through this first step.

The second magnet parts having a gross magnetic charge that is greater than the gross magnetic charge of the first magnet parts are disposed around the first magnet parts. As a result, a portion of the magnetic lines of force that are emitted from the second magnet parts form a closed-loop, magnetic circuit between the first and second magnet parts, and the remainder are in the state of extending toward the side of the wafer placed opposite the sputtering target. The magnetic lines of force that extend towards this wafer side are in the state of existing between the generated plasma and the chamber-side wall, thus the phenomenon where among the high energy electrons (secondary electrons) emitted from the sputtering target by sputtering, the electrons collected in the magnetic field that appear on the erosion surface, for example flow out to the side of the reference potential member, such as a shield member provided on the side of the chamber side wall, can be surely prevented, effectively confining the electrons in the neighboring region of the sputtering target.

Furthermore, by making the gross magnetic charge of the second magnet parts, which are positioned on the outer side in relation to the first magnet parts, larger than the gross magnetic charge of the first magnet parts, magnetic lines of force are formed extending from the sputtering target to the wafer side, and these magnetic lines of force allow the electrons to leave the sputtering particles that run towards the wafer side, facilitating the ionization of the sputtering particles. The ionized sputtering particles then change their kinetic direction so as to head towards the sputtering target through the influence of the electric field, which is formed by applying voltage to the sputtering target, then are accelerated, colliding into the sputtering target. The sputtering target is sputtered by the energy at the time of this collision, becoming the so-called state of self-sputtering.

When self-sputtering begins to occur, normal sputtering due to the transformation of process gas into plasma and self-sputtering co-exist (the transition state). From this state, normal sputtering due to the transformation of process gas into plasma has a decreasing tendency when the gas supplying means decreases the amount of process gas supplied to the chamber. At this time, ionization of the sputtering particles is facilitated and self-sputtering can be more effectively sustained through the function of the magnetic lines of force formed extending from the sputtered target to the wafer side.

Accordingly, normal sputtering tends to reduce when the amount of process gas supplied to the chamber is reduced by the second step, and under the conditions of the supply of process gas being stopped, it comes to be in a state where film deposition is performed by only self-sputtering.

The above and other features and advantages of the present invention will become more apparent by reading the following detailed description to those skilled in the art, while referring to the attached drawings.

### Brief Description of Drawings

Fig. 1 is a schematic view of a magnetron sputtering apparatus, according to the present invention;
Fig. 2 is atop plan view showing a layout of each magnetron unit;
Fig. 3 is an enlarged view of a magnetron unit with an enlarged subunit;
Fig. 4 is an enlarged view of a magnetron unit with an enlarged subunit;
Fig. 5 is an enlarged view of a magnetron unit with an enlarged subunit;
Fig. 6 is an enlarged view of a magnetron unit with an enlarged subunit;
Fig. 7 is a view showing a magnetic field that is formed on the sputtering apparatus of the present invention;
Fig. 8 is a view showing a magnetic field that is formed on the sputtering apparatus of the present invention;
Fig. 9 shows a timing chart for operating the sputtering apparatus;
Fig. 10A is a pattern diagram for describing the state of normal sputtering;
Fig. 10B is a pattern diagram for describing the transition state;
Fig. 10C is a pattern diagram for describing the state of self-sputtering;
Fig. 11 is a schematic view of a magnetron sputtering apparatus according to another embodiment;
Figs. 12A and 12B are explanatory views two-dimensionally illustrating the positional relationship between the sputtering target, and the magnets and base plates in the magnetron unit of Fig. 11;
Fig. 13 is a broken-away oblique perspective view showing the magnetron unit shown in Fig. 11; and
Fig. 14 is an explanatory view two-dimensionally illustrating the positional relationship between the sputtering target, and the magnets and base plates of the magnetron unit according to another embodiment.

### Best Mode for Carrying Out the Invention

In the following, the preferred embodiments of the present invention are described along with the Figures. It is noted here that throughout all of the drawings, the same or corresponding parts are labeled with the same respective reference numeral.

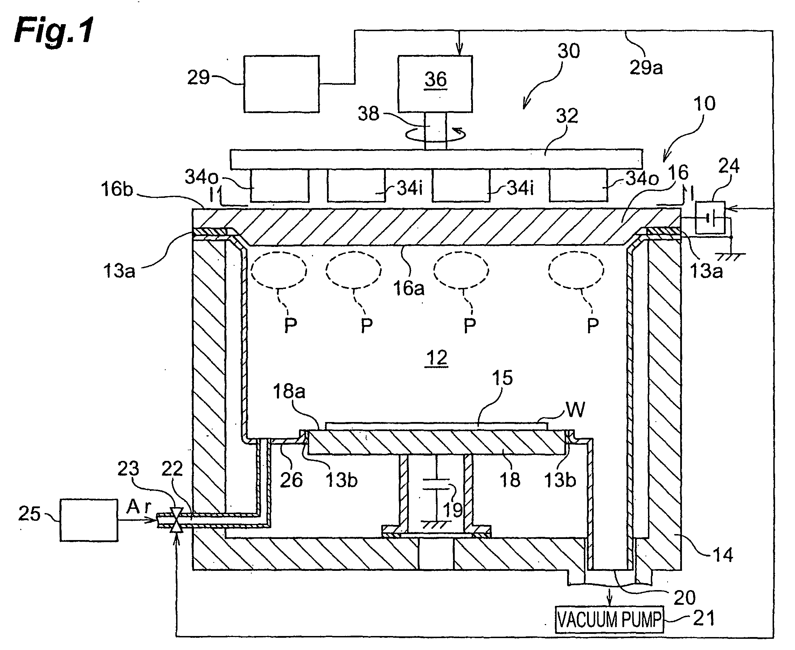

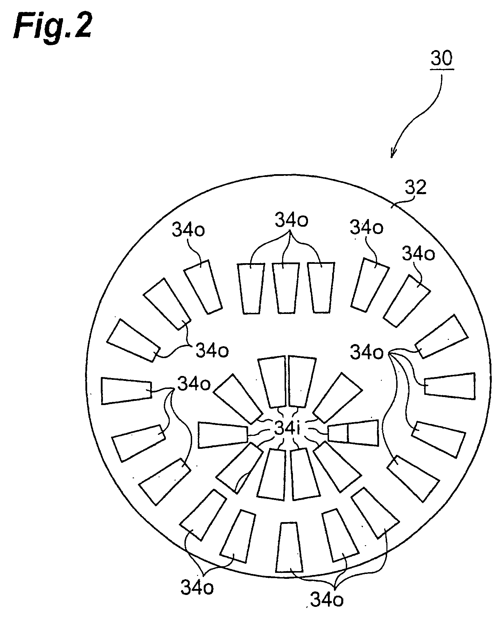

A sputtering apparatus according to an embodiment of the present invention will be described. Fig. 1 is a schematic block diagram of the magnetron sputtering apparatus according to the present invention. Fig. 2 shows an outline of a magnetron unit and the layout of a plurality of subunits therein. Fig. 2 also shows the cross section cut along the line I to I of Fig. 1.

Sputtering apparatus 10 comprises housing 14, which forms vacuum chamber 12 therein, and target 16, which is configured so as to close the upper-side opening of housing 14. Due to both housing 14 and target 16 being made of conductive material, insulating member 13a is wedged between housing 14 and target 16. In the embodiment shown in Fig. 1, housing 14 has a circular base and a tubular side that extends for only a predetermined distance from the periphery of this circular base, and for example the tubular side has a hollow cylindrical shape. The shape of target 16 is discus. One circular surface 16a (hereafter referred to as under surface) of target 16 is the erosion surface that undergoes erosion through sputtering.

Pedestal 18 is disposed in vacuum chamber 12 as a substrate-supporting means (also called substrate-supporting portion) . Pedestal 18 supports substrate 15 within vacuum chamber 12. Due to this, pedestal 18 holds to-be-processed substrate 15, for example a semiconductor wafer W or glass substrate, on one of its surfaces (hereafter referred to as upper surface) 18a. Upper surface 18a of pedestal 18 faces undersurface (erosion surface) 16a of target 16. To-be-accumulated surface 15a of substrate 15 (wafer W) held at a predetermined position on pedestal 18 is configured parallel to undersurface 16a of target 16. Substrate 15 is configured so that its center is aligned with the center of target 16, in other words concentrically positioned. It is preferred that this center is identical with the center of rotation of the magnetron unit, so that the uniformity within the formed film surface can be improved. The dimensions of target 16 and the spacing between pedestal 18 and target 16 in the present embodiment may have the same values as the conventional standard sputtering apparatus.

Sputtering apparatus 10 comprises shield 26 to prevent the sputtering particles from reaching the inner wall surface, so the inner wall surface of vacuum chamber 12 can be protected from the sputtering particles. An edge portion of one end of shield 26 is wedged between housing 14 and insulating member 13a, wherein one end of shield 26 is fixed by the upper-side opening of housing. Another end of shield 26 reaches the side surface of pedestal 18. The edge portion of another side is fixed via insulating member 13b along the side surface of pedestal 18. As a result, shield 26 and pedestal 18 are electrically insulated. Shield 26 is connected to a reference potential. Pedestal 18 is connected to a reference potential, for example a ground potential, via capacitor 19.

Discharge port 20 is formed in housing 14. In the case of the present embodiment, vacuum pump 21, such as a cryopump and the like, is connected to discharge port 20. Due to the operating of this vacuum pump 21, vacuum chamber 12 can be depressurized. Discharge port 20 and vacuum pump 21 structure a depressurizing means. Argon gas, which is used as a process gas, is supplied inside vacuum chamber 12 from process gas supply source 25 via supplying port 22. Supplying port 22 can be open and shut by valve 23. Opening and shutting this valve 23 allows for the control of whether process gas is supplied or not, the supplied amount, as well as the supply timing. Supplying port 22 and process gas supply source 25 structure a process gas supplying means.

The negative and positive electrodes of accelerating power source 24, which is a plasma generating means, are connected to target 16 and shield 26, respectively. When process gas (argon gas) is introduced into vacuum chamber 12 and a voltage is applied between target 16 and shield 26, glow discharge occurs resulting in a plasma state. When the argon ions generated by this glow discharge collide with under surface 16a of target 16, the atoms (sputtering particles) structuring target 16 are driven out. When these target atoms reach and are accumulated on wafer W, a film is formed on wafer W.

Magnetron unit 30 faces the surface opposing undersurface 16a of target 16, namely upper surface 16b of target 16. The magnetron unit functions to increase the plasmatic density in the vicinity of the erosion surface of target 16.

Fig. 2 is a top plan view illustrating the layout of each magnetron unit. Referring to Figs. 1 and 2, magnetron unit 30 comprises a circular base plate 32 and a plurality of subunits (magnets) 34, which are fixed in a predetermined arrangement upon base plate 32. Base plate 32 is disposed above target 16, and at the center of its upper surface is connected to revolving shaft 38 of driving motor 36. Accordingly, when base plate 32 is rotated by operating driving motor 36, gyrating each magnet 34 along the upper surface of target 16, the magnetic field gene rated by magnets 34 is then prevented from coming to a rest at one place.

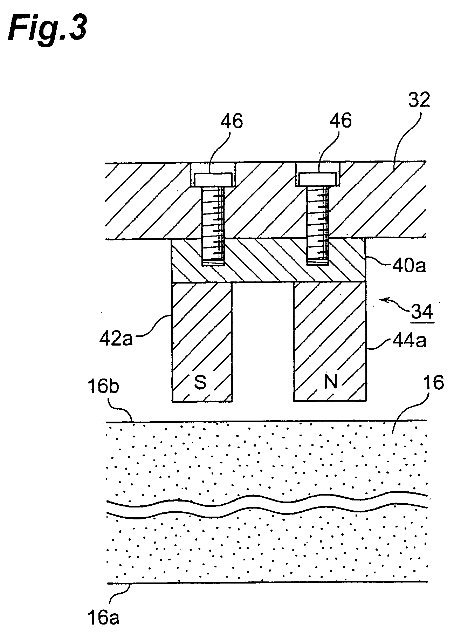

Figs. 3 to 6 illustratively show the subunits applicable to sputtering apparatus 10.

Fig. 3 is a cross-sectional diagram of one magnetron unit with an enlarged subunit. As demonstrated in Fig. 3, respective subunits 34 are configured from magnetic member 40a and bar magnets 42a and 44a. Magnetic member 40a may be a tabular yoke member made of a magnetic substance. Bar magnets 42a and 44a respectively have an S pole at one end and an N pole at the other end. Bar magnet 42a is disposed facing the one end indicating the S polarity towards target 16, and bar magnet 44a is disposed facing the one end indicating the N polarity towards the target. Bar magnet 42a has its other end indicating an N polarity touching magnetic member 40a, bar magnet 44a has its other end indicating an S polarity touching magnetic member 40a, and they are fixed to respective ends of magnetic member 40a. The two bar magnets 42a and 44a extend in the same direction, and the overall shape of magnet 34 is an approximate U-shaped form. On one side, the free end of bar magnet 42a is the N pole, and on the other side, the free end of bar magnet 44a is the S pole. In addition, magnets 42a, 44a and magnetic member 40a structure a magnetic circuit, thus structuring a magnet means for functioning as one body of magnetic substance with differing magnetic pole facing in the same direction.

In the subunit shown in Fig. 3, a first magnet part configures magnet 44a, and a second magnet part configures magnet 42a. The magnetic charge of the first magnet part (magnet 44a) is greater than the magnetic charge of the second magnet part (magnet 42a). Therefore, the magnetic charge of magnet 42a is smaller than that of magnet 44a. As a result, a portion of the magnetic lines of force associated to the free end N pole of magnet 44a extend out from the N pole passing through the vicinity of erosion surface 16a, reaching the free end S pole of magnet 42a. The magnetic lines of force remaining from the magnetic lines of force associated with the free end N pole of magnet 44a extend out from the N pole in a direction perpendicular to erosion surface 16a, reaching the S pole of magnet 44a again by passing through vacuum chamber 12 (see Fig. 1).

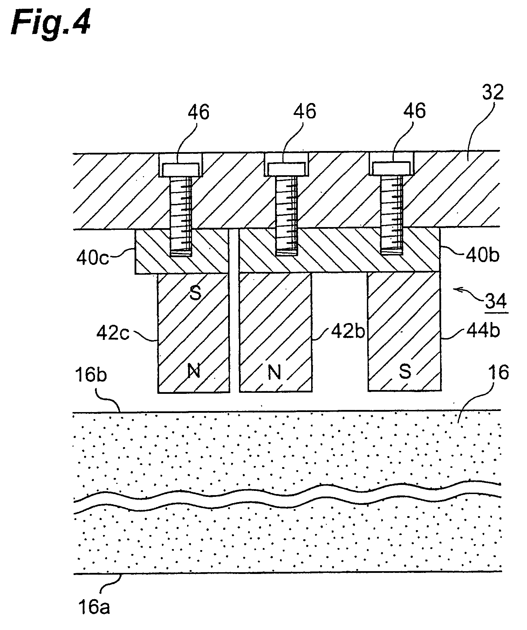

Fig. 4 is a cross section diagram of one magnetron unit with an enlarged subunit. As demonstrated in Fig. 4, each subunit 34 is structured by magnetic members 40b and 40c, and bar magnets 42b, 44b and 42c. Magnetic members 40b and 40c may be tabular yoke members made of a magnetic substance. Bar magnets 42b, 44b and 42c respectively have an S pole at one end and an N pole at another end. Bar magnets 42b, 44b and 42c may have the same magnetic charge. Bar magnets 42b and 42c are respectively disposed with the one end indicating the N polarity facing towards target 16, and bar magnet 44b is disposed with the end indicating the S polarity facing towards the target. Bar magnet 42b has its other end indicating an S polarity touching magnetic member 40b, bar magnet 44b has its other end indicating an N polarity touching magnetic member 40b, and they are fixed to respective ends of magnetic member 40b. Bar magnet 42c has its other end indicating an S polarity touching magnetic member 40c, and is fixed to, for example one end of this magnetic member 40c. The three bar magnets 42b, 44b and 42c all extend in the same direction. The free end of bar magnet 42b is an N pole, the free end of bar magnet 44b is an S pole, and the free end of the additional bar magnet 42c is an N pole. In addition, magnets 42b and 44b, and magnetic member 40b structure a magnetic circuit, thus structuring a magnet means for functioning as one body of magnetic substance with differing magnetic polarity facing in the same direction. The magnetic lines of force that extend out from the free end of magnet 42b reach the free end of magnet 44b. Magnet 42c and magnetic member 40c structure a magnetic circuit, thus are a magnet means for functioning as one body of magnetic substance. The magnetic lines of force that extend out from the free end N of magnet 42c reach magnetic member 40c.

In the subunit shown in Fig. 4, magnet 42c is disposed parallel to magnet 42b. A first magnet part comprises magnets 42b and 42c, and a second magnet part comprises magnet 44b. The magnetic charge of the second magnet part (magnet 44b) is smaller than the magnetic charge of the first magnet part (magnets 42b and 42c) . As a result, a portion of the magnetic lines of force associated with the free end N pole of the first magnet part (magnets 42b and 42c) extend out from the N pole passing through the vicinity of erosion surface 16a, reaching the free end S pole of the second magnet part (magnet 44b). The remaining portion of the magnetic lines of force that extend out from the first magnet part extend in a direction perpendicular to erosion surface 16a, in other words it extends from target 16 in the direction towards substrate-supporting portion 18, and without reaching the second magnet part, returns once again to the first magnet part by passing through vacuum chamber 12 (see Fig. 1).

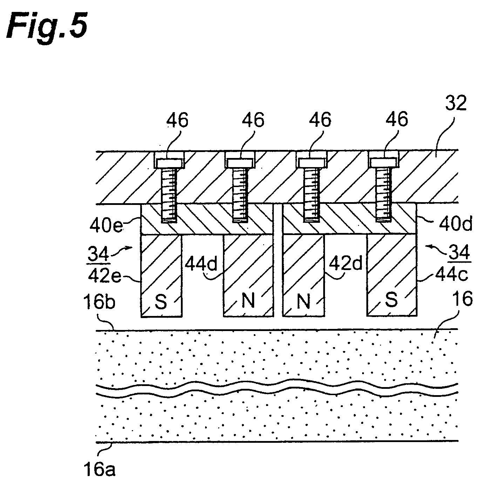

Fig. 5 is a cross section diagram of one magnetron unit with an enlarged subunit. As demonstrated in Fig. 5, respective subunits 34 are structured by magnetic members 40d and 40e, and bar magnets 42d, 42e, 44c and 44d. Magnetic members 40d and 40e may be tabular yoke members made of a magnetic substance. Bar magnets 42d, 42e, 44c and 44d respectively have an S pole at one end and an N pole at the other end.

Bar magnet 42d (44d) is disposed with one end indicating an N polarity facing target 16, and bar magnet 44c (42e) is disposed with one end indicating an S polarity facing the target. Bar magnet 42d (44d) has its other end indicating an S polarity touching magnetic member 40d (40e), bar magnet 44c (42e) has its other end indicating an N polarity touching magnetic member 40d (40e), and they are fixed to respective ends of magnetic member 40d (40e). The two bar magnets 42d (44d) and 44c (42e) extend in the same direction, and the overall shape of magnet 34 is approximately a U-shaped form. On one side, the free end of bar magnet 42d (44d) is the N pole, and on the other side, the free end of bar magnet 44c (42e) is the S pole. In addition, magnets 42d (44d) and 44c (42e) and magnetic member 40d (40e) structure a magnetic circuit, thus structuring a magnet means for functioning as one body of magnetic substance with differing magnetic polarity facing in the same direction.

In addition, the subunit shown in Fig. 5 comprises a magnet assembly made from magnets 42d and 44c, and magnetic member 40d, and a magnet assembly made from magnets 42e and 44d, and magnetic member 40e. These magnet assemblies have bar magnets 42d and 44d, which have the same magnetic polarity facing the target, facing each other, for example, arranged in a row. Even in the case where respective magnet assemblies have the same magnetic properties, since magnets 42d and 44d indicating the same magnetic pole are adjacently disposed alongside each other, a portion of the magnetic lines of force that extend out from the free end N pole extend out in a direction perpendicular to erosion surface 16a, passes through the vacuum chamber (numeral 12 in Fig. 1), and reaches the free end S poles of respective magnetic circuits without spreading in the direction of where the magnets indicating the same polarity are disposed. The remaining portion of the magnetic lines of force associated with the free end N poles of magnets 42d and 44d extend out from the N pole, pass through the vicinity of erosion surface 16a, and reach the free end S poles of magnets 42e and 44c. respectively.

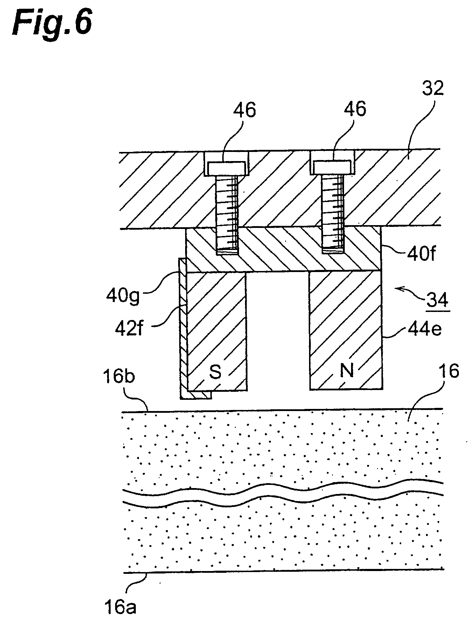

Fig. 6 is a cross section diagram of one magnetron unit with an enlarged subunit. As demonstrated in Fig. 6, respective subunits 34 are structured by magnetic members 40f and 40g, and bar magnets 42f and 44e, and have the same structured magnet assembly as the magnet assembly shown in Fig. 5, and magnetic member 40g. Magnetic member 40g is disposed running from one end of magnet 42f that indicates one magnetic polarity to the other end that indicates the other magnetic polarity. Therefore, magnetic member 40g functions in order for one end (S pole) of magnet 42f to magnetically bond with magnetic member 40f. In other words, a portion of the magnetic lines of force associated with the free end of magnet 42f pass through magnetic member 40g, reaching the fixed end of magnet 42f. As a result, a portion of the magnetic lines of force from magnet 42f closes the loop without extending into vacuum chamber 12. Accordingly, a portion of the magnetic force lines associated with magnet 44e extends out in a vertical direction from the N pole to erosion surface 16a, passes through the vacuum chamber (numeral 12 in Fig. 1), and reaches the S pole of magnet 44e once again via magnetic member 40g. The remaining portion of the magnetic lines of force associated with the free end N pole of magnet 44e extends out from the N pole, passes through the vicinity of erosion surface 16a, reaching the free end S pole of magnet 44e.

Referencing Fig. 2 once again, respective subunits 34 (34o and 34i) are disposed above target 16 so that their free ends respectively face surface 16b, which opposes under surface 16a of target 16. Such subunits 34 are fixed onto base plate 32 by an appropriate fastening means, for example screw 46 and the like, under the condition that the backsides of yoke members 40a through 40f touch base plate 32. With such a structure, it is possible to freely change the fixed positions of subunits 34.

A variety of configurations for subunits 34 may be considered, however in the embodiments, subunits 34 are in a double-ring configuration as shown in Fig. 2. This ring configuration of all magnets is made from a group of inner-side circular magnets 34i (suffix i denotes the inner-side circular configuration) and a group of outer-side circular magnets 34o (suffix o denotes the outer-side circular configuration). By forming a magnetic field in the space near under surface 16a of target 16, respective subunits 34i and 34o can control the plasma of process gas formed in said space.

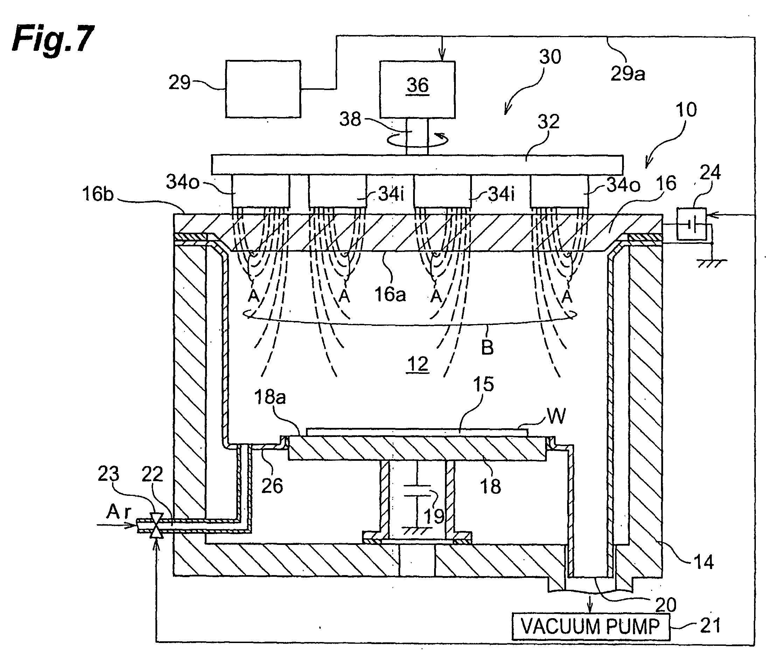

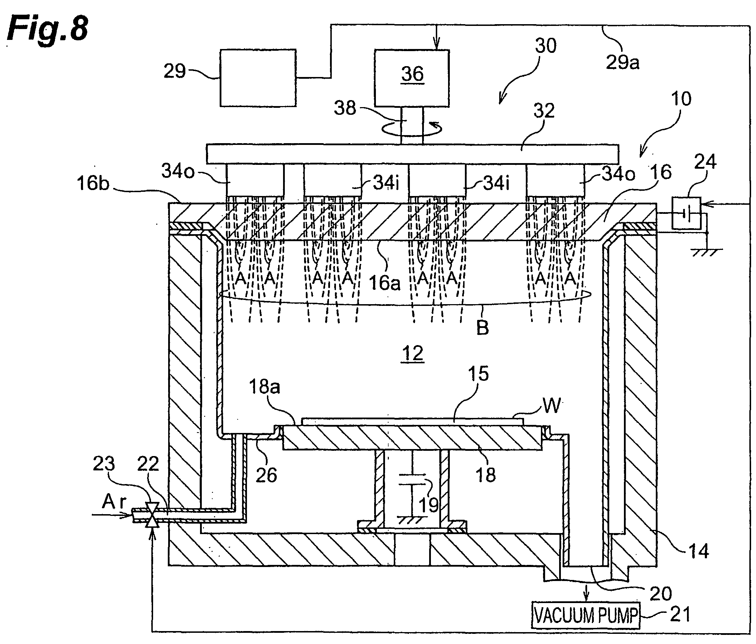

Fig. 7 schematically illustrates the magnetic field generated when the subunits shown in Figs. 3, 4 and 6 are applied to sputtering apparatus 10. Fig. 8 schematically illustrates the magnetic field generated when the subunit in Fig. 5 is applied to sputtering apparatus 10. Figs. 7 and 8 show by dashed lines the magnetic field generated by each subunit 34. In the vicinity of erosion surface 16a, the magnetic fields H that each respective subunit generates mainly have components in the direction parallel to this surface 16a (parallel components Hh), and in the space away from erosion surface 16a, mainly have axial (reference axis) components (vertical components Hv) running from target 16 towards substrate-supporting portion 18.

Each subunit controls the ratio of vertical components Hv to horizontal components Hh of the magnetic fields H formed in the space (hereafter referred to as the self-sputtering space) within vacuum chamber 12, which is between erosion surface 16a and upper surface 18a of pedestal 18. It is noted here that due to magnetron unit 30 being rotated by driving motor 36, the magnetic fields generated by respective subunits 34i and 34o rotate around drive shaft 38 in an actual sputtering apparatus. Thus, the magnetic field components parallel to the reference axis in the self-sputtering space are effectively generated.

With such sputtering apparatus, process gas is transformed into plasma by magnetron unit 30 in the vicinity of erosion surface 16a. As a result, sputtering particles are generated from erosion surface 16a of target 16. In addition, since subunits as shown in Figs. 3 through 6 are disposed in the magnetron unit, a magnetic field, which has magnetic field components in the direction perpendicular to erosion surface 16a that are greater than the magnetic field components that are in the horizontal direction thereof, is generated in a region differing from the vicinity of erosion surface 16a. The sputtered particles are efficiently ionized in the region within vacuum chamber 12 where the vertical components of the magnetic field are dominant over the horizontal components. Therefore, the ionized sputtering particles are accelerated towards eroded surface 16a, and other sputtering particles are generated when they collide with eroded surface 16a. Hence, self-sputtering successively occurs.

Referencing Fig. 1 once again, sputtering apparatus 10 comprises controller 29. Since controller 29 has a microcomputer, a timer and the like, the control of turning on and off the electric current, and also including the temporal control of the change in value of electric current, for example, can be carried out. Controller 29 is connected to valve 23, accelerating power source 24, and driving motor 36 via control line 29a. Controller 29 can control these instruments while mutually associating them. As a result, the supply of process gas, the generation of process gas plasma, and the transition into self-sputtering and the like can be controlled in sync with a predetermined timing.

In the following description, a case where the target has copper as the primary structural element is described. In other words, a copper thin film accumulates upon wafer W through sputtering. However, the target material that is applicable to sputtering apparatus 10 is not limited to copper. Film deposition is possible with other elements such as palladium and gold through the use of self-sputtering.

Each subunit 34 (34i and 34o) included in magnetron unit 30 forms troidal magnetic fields A, as shown using dashed lines in Figs. 7 and 8. In the vicinity of erosion surface 16a of target 16, these annular magnetic fields A have components Hah (horizontal components) of magnetic fields parallel to this surface 16a as main components. Since these magnetic field components Hah allows for an increase in the plasmatic density formed by argon discharge in the vicinity of erosion surface 16a of target 16, sputtering of these magnetic field components Hah using argon is facilitated in large regions (dashed line region P in Fig. 1). However, these magnetic field components Hah do not facilitate ionization, namely transformation of the sputtering copper particles into plasma.

On the other hand, subunits 34 generate magnetic field B in the self-sputtering space, which is in a different place than the neighboring region of erosion surface 16a. In this space, magnetic field B has magnetic field components (vertical components) Hbv facing in the direction of the reference axis as the main components. These components are magnetic field components Hbv that are perpendicular to erosion surface 16a. These magnetic field components Hbv allow the electrons to leave the copper atoms Cu (sputtering particles), which have components of velocity perpendicular to erosion surface 16a, facilitating the ionization of copper atoms Cu. As a result, magnetic field B serves in the manner as follows.

To begin with, the copper atoms Cu sputtered by argon proceed towards wafer W through the self-sputtering space. In mid-course, being affected by vertical components Hbv of magnetic field B, a certain percentage of the copper atoms Cu are ionized, generating copper ions Cu⁺. The ionized copper Cu⁺ interacts with the electric field that runs from shield 26 towards target 16, subjected to coulomb force. As a result, the atoms that have a smaller kinetic energy than potential energy at the time of ionization change the kinetic direction to face erosion surface 16a of target 16. They are then accelerated corresponding to the potential energy of respective Cu⁺, having the kinetic energy corresponding to the sum energy of the kinetic energy at the time of being ionized and the potential energy at the time of being ionized, and colliding with erosion surface 16a. When energy during this collision is sufficient for sputtering other atoms from the target, the next sputtering atoms are generated through sputtering using Cu⁺. These atoms proceed towards wafer W through the self-sputtering space in correspondence with the initial velocity.

In other words, the process progresses in the order of (1) generation of copper atoms Cu through sputtering, (2) flight of generated copper atoms through the magnetic field, (3) ionization of these copper atoms by the vertical magnetic field components, (4) acceleration of the copper ions Cu⁺ by the electric field, (5) collision of these copper ions Cu+ to target 16, (6) generation of other copper atoms through self-sputtering, and (7) flight of the generated copper atoms through the magnetic field. A portion of the generated copper particles, including those ionized and those not ionized, reach the surface of wafer W, accumulating thereon.

When such processes progress and the ionized copper ions are more in number than the non-ionized copper atoms, self-sputtering is sustained. However, if the supply of argon gas is stopped, so as to decrease the number of copper atoms generated by the process gas, there may be cases where self-sputtering ceases to develop because the number of copper atoms and copper ions do not suffice. On the other hand, if the state where the ionized copper ions are more in number than the non-ionized copper atoms is maintained, self-sputtering is sustained even without supplying process gas. When in this state, sputtering progresses even if argon gas is not supplied as a process gas. In other words, self-sputtering progresses. In order to arrange such conditions, the condition where the magnetic field components running in the direction perpendicular to the target exists is important. Also, before reaching this state, adequately transforming argon gas into plasma, and initially supplying copper atoms are also important.

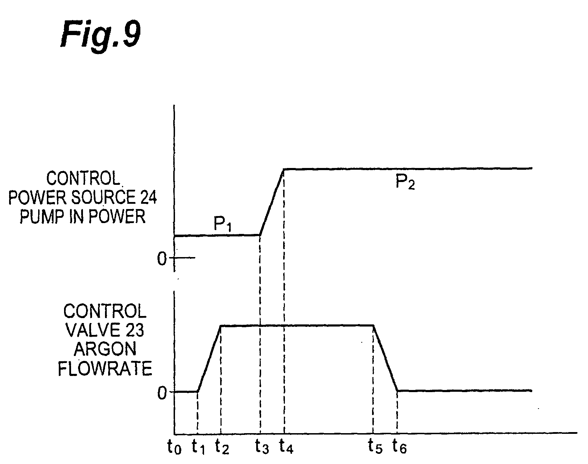

A method of optimally realizing such self-sputtering phenomena in the sputtering apparatus of the'present embodiment will be described. Fig. 9 shows a timing chart for operating the sputtering apparatus. Fig. 9 shows the control of the flow rate of argon carried out by valve 23, and the control of the power between target 16 and shield 26 by power source 24, with the horizontal axis being the time axis.

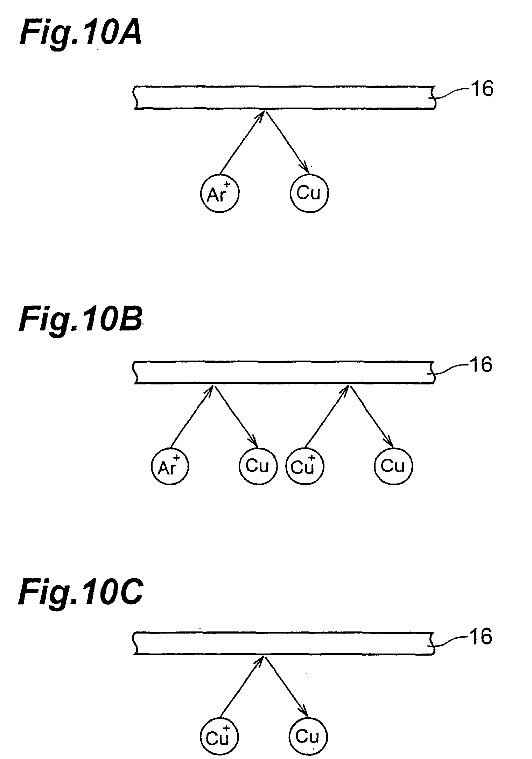

Referring to Fig. 9, at time t0, voltage from power source 24 is applied in between target 16 and shield 26. At time t1, valve 23 is open and the supply of process gas (argon gas) into vacuum chamber 12 begins. At time t2, a suitable degree of vacuum for glow discharging is reached, thus valve 23 is fixed. In the process up to this point, and also from hereafter, vacuum discharge is continuously carried out by a vacuum pump. Although not shown in Fig. 9, when magnetron unit 30 is activated, argon plasma is efficiently formed in the vicinity of erosion surface 16a (region P in Fig. 1). At this time, power P1 is pumped in from power source 24. Through the activity of the argon plasma, sputtered copper atoms are generated from erosion surface 16a of target 16. This state is illustrated in Fig. 10A. Namely, argon ions collide with the target, causing the copper atoms to sputter (normal sputtering state).

Afterwards from time t3 till time t4, power from power source 24 increases further. P2 denotes the power at time t4. At this time, sputtering by argon is sustained.

Next, in such processes, under the influence of magnetic field B, self-sputtering breaks out. At this time, there are sputtered copper atoms resulting from argon ions and those from copper ions themselves. However, since magnetic field B is generated so that it runs in an appropriate direction, conditions for sustaining self-sputtering are satisfied. This state is illustrated in Fig. 10B. Namely, the case where argon ions collide with the target causing the copper atoms sputtering, and the case where copper ions collide with the target causing the copper atoms sputtering, coexist (transition state).

While the flow rate of argon begins to drop at time t5, the supply of argon stops at time t6. At time t6, when the supply of process gas is completely stopped, copper atoms are supplied by self-sputtering only. This state is illustrated in Fig. 10C. Namely, copper ions collide with the target, causing the copper atoms to sputter (self-sputtering state).

The above generates a plasma of process gas, and after generating sputtering particles from this plasma, the sputtering particles are ionized by the vertical magnetic field. As a result, the normal spattering state can change into the transition state. In the transition state, the region of the process gas plasma and the region of the ionized sputtering particles differ, thus self-sputtering stabilizes and progresses without mutual interference. Hence, even if the process gas plasma is omitted, the self-sputtering state is sustained.

In the self-sputtering method as described above, after supplying process gas into vacuum chamber 12, since it is rendered to transform the process gas into plasma in the neighboring region of erosion surface 16a of target 16, sputtered particles are generated from erosion surface 16a. Since it is also rendered to generate a magnetic field that runs along a reference axis approximately orthogonal to erosion surface 16a in a region within vacuum chamber differing from the above neighboring region, a region wherein the magnetic field components run in the direction parallel to the reference axis are dominant over the components orthogonal thereto, is formed in vacuum chamber 12. In this region, sputtering particles can be easily ionized. When ionized particles are accelerated towards target 16 and these particles reach erosion surface 16a, other sputtering particles are generated. As a result, self-sputtering successively progresses along with normal sputtering.

In addition, when the supply of process gas is stopped, only by the partial pressure of the process gas does the degree of vacuum increase. On the other hand, since predetermined magnetic fields are generated by the subunits, even if there is no supply of process gas, generation of sputtering particles through self-sputtering is sustained. Also, the colliding of process gas particles with sputtering particles no longer occurs. As a result, particles generated through self-sputtering are sequentially accumulated onto the surface of the substrate. Accordingly, a film with favorable bottom coverage is accumulated upon the substrate.

The following describes the case where such self-sputtering is applied to a film deposition method. This film deposition method of forming film using particles sputtered from the target by particles sputtered from the target, which is provided within the vacuum chamber, comprises: a step of positioning a substrate having a surface whereon a film is to be deposited; a supplying step of supplying process gas into the vacuum chamber; a plasma step of generating sputtering particles from a target by forming plasma of process gas in the vicinity of a erosion surface; a self-sputtering step of generating sputtering particles from the target through self-sputtering by generating a magnetic field along a reference axis, which connects the erosion surface of the target to a surface of the substrate, in the space between the erosion surface of the target and the surface of the substrate; and a stopping step of stopping the supplying of process gas after the self-sputtering step.

In this manner, when the particles generated through self-sputtering are successively accumulated onto the surface of the substrate, a filmwith favorable bottom coverage is accumulated upon the substrate. Also, even if there is no supply of process gas, since an appropriate magnetic field and electric current are applied, the generation of sputtering particles through self-sputtering is sustained. On the other hand, when the supply of process gas is stopped, only by the partial pressure of the process gas does the degree of vacuum increase. As a result, since the colliding of process gas particles with sputtering particles no longer occurs, the bottom coverage rate further improves.

Now, another embodiment of a sputtering apparatus will be described, wherewith film deposition through such self-sputtering can be carried out.

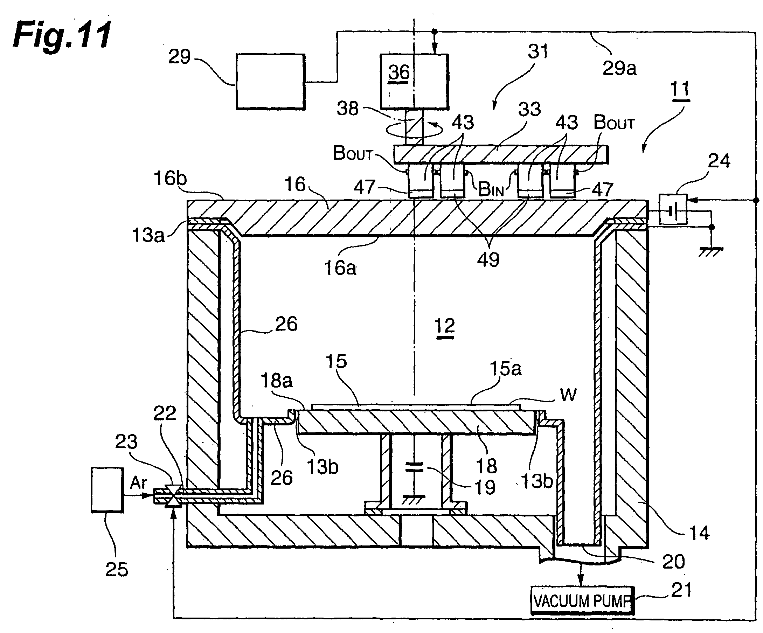

In Fig. 11, sputtering apparatus 11 according to another embodiment is shown. It is noted here that the members having the same functions as sputtering apparatus 10 shown in Fig. 1 are labeled with the same respective reference numerals. In Fig. 11, magnetron unit 31 is disposed in place of magnetron unit 30 of Fig. 1.

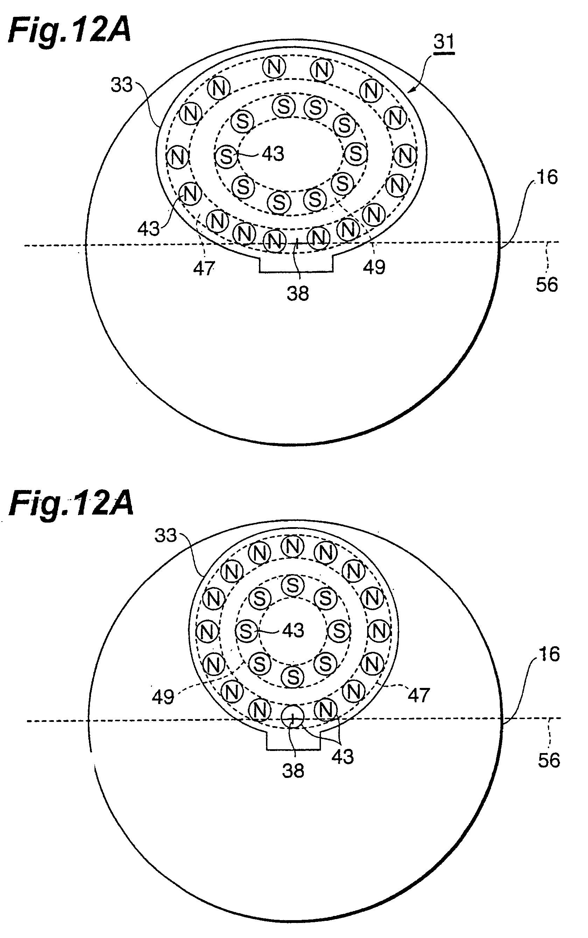

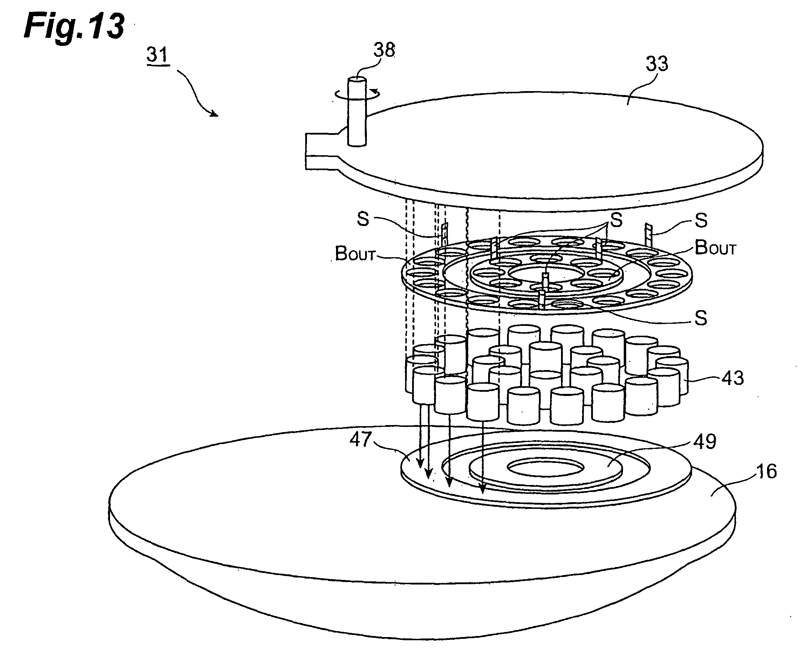

In Figs. 12 and 13, magnetron unit 31 and sputtering target 16 are illustrated.

Magnetron unit 31 is structured of, for example, base plate 33 formed of a magnetic substance; a plurality of magnets 43; inner belt Bin and outer belt Bout, which position each magnet 43; and magnetic members 49 and 47, which are fixed at the end of each circularly arranged magnet.

Base plate 33 takes on the combined shape of a circular region and a rectangular region, wherein each magnet 43 is arranged on the side of the circular region, one end portion of rotating shaft 38 that rotationally drives base plate 33 near the joining region of the circular region and the rectangular region is fixed.

Inner belt Bin and outer belt Bout are made of non-magnetic material and are used as positioning members for magnets 43, wherein openings equal in size to the external diameter of magnets 43 are formed at predetermined intervals. By inserting magnets 43 inside each opening, each magnet 43 is arranged in a state of being scattered about in two circular sequences along the concentrically configured inner belt Bin and outer belt Bout. Here as an example, the S poles of magnets 43 on the inner belt Bin side, and the N poles of magnets 43 on the outer belt Bout side are respectively arranged so as to face sputtering target 16. In addition, space S made of a non-magnetic substance lies in between base plate 33, and inner belt Bin and outer belt Bout, and due to this, inner belt Bin and outer belt Bout are in an estranged state from base plate 33.

Among magnets 43 circularly arranged in this manner, circular magnetic members 49, which are formed of pole pieces or yokes and the like, are fixed by magnetic force at the end surfaces of each magnet 43 (the end surface opposing the side of sputtering target 16), which are arranged by inner belt Bin; and due to this, the S poles of each adjacent magnet 43 are mutually connected, being in a state of forming a ring-shaped S pole. Also in the same way, magnetic members 47, which are made of magnetic substance, are also fixed by magnetic force at the end surfaces of each magnet 43 (the end surface opposing the side of sputtering target 16), which are arranged by outer belt Bout; and due to this, the N poles of each adjacent magnet 43 are mutually connected, being in a state of forming a ring-shaped N pole. Then, magnetic members 49 and inner belt Bin are fixed by tie pins (not shown in the Figure) of non-magnetic material, which penetrate them, opposing base plate 33, and also in the same way, magnetic members 47 and outer belt Bout are fixed by tie pins (not shown in the Figure) of non-magnetic substance, which penetrate them, opposing base plate 33.

In this manner, a magnetic circuit with a closed doughnut shape is formed by all of magnets 43 that are arranged on the inner side and all of magnets 43 that are arranged on the outer side.

It is noted here that in Fig. 12A, the case where magnets 43 are arranged upon the ellipse circumference is graphically represented, however, it is not limited to this example, but for example, as shown in Fig. 12B, it may adopt the structure that arranges magnets 43 upon a circumference that is closer to a perfect circle. In this case, it is preferable that the members corresponding to inner belt Bin, outer belt Bout, and magnetic members 49 and 47 are formed in a toric shape.

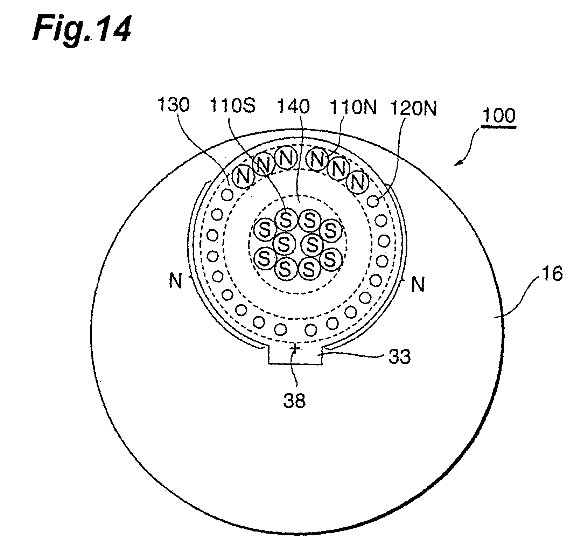

Also, a magnetron unit may be structured as shown in Fig. 14. This magnetron unit 100 has two types of columnar magnets differing in diameter fixed by magnetic force on the surface of base plate 33, which is made of magnetic material. For example, the diameter of the large diameter magnet with the larger diameter is approximately 1.7 cm, and the diameter of the small diameter magnet with the smaller diameter is approximately 1.4 cm. The height of both types of magnets is the same, for example approximately 3.3 cm. The magnetic force that comes from the large diameter magnet is approximately 150 to 200 gauss in the space 2 cm away from one end of the large diameter magnet, and the magnetic force that comes from the small diameter magnet is approximately 60 to 70% of that of the large diameter magnet.

As shown in Fig. 14, six large diameter magnets 110N are arranged along the circumference at the outer rim of base plate 33, which is the region furthest from the central portion of sputtering target 16; furthermore, nine small diameter magnets 120N are arranged along the same circumference respectively on both sides of these six large diameter magnets so as to be sandwiched therewith. Accordingly, the circular region of base plate 33 is in a state of being surrounded by all of these large diameter magnets 110N and small diameter magnets 120N. In the example of Fig. 14, these large diameter magnets 110N and small diameter magnets 120N are arranged facing the N poles towards sputtering target 16, and magnetic member 130 made of yoke and the like, is fixed by magnetic force at the end surfaces of large diameter magnets 110N (the end surfaces opposing the sputtering target 16) and small diameter magnets 120N, formed in a ring-shape along this arrangement.

In contrast, 10 large diameter magnets 110S are arranged in an assembled state at the center portion of base plate 33, and each large diameter magnet 110S is in the state of the S polarity facing sputtering target 16. Then, magnetic member 140 that takes on a circular plate shape is fixed by magnetic force at the end surfaces of each large diameter magnet 110S (the end surface opposing sputtering target 16) so that it covers the assembly region of large diameter magnets 110S, made of the same substance as magnetic member 130.

Even in the embodiment shown in Fig. 14, in the arrangement of each respective magnet 110N, 110S, and 120N, a positioning member (not shown in the Figure) made of non-magnetic material that was already graphically represented as inner belt Bin for example, is used, and are arranged on the surface of base plate 33 in the positioned state by this positioning member.

By structuring a magnetron unit as shown in Fig. 14, the magnetic charge generated from all of the magnets arranged at the outer rim of base plate 33 becomes greater than the magnetic charge generated from all of the magnets arranged at the center portion of base plate 33. As a result, among the high energy atoms (secondary atoms) emitted from sputtering target 16 through sputtering, the phenomenon, wherein the atoms collected by the magnetic field that is present in erosion surface 16a flow out to shield 26 that is positioned on the side of vacuum chamber 12 side wall, can be sufficiently controlled, and the atoms can be effectively confined in the neighboring region of the sputtering target.

In addition, since the fact that the magnetic lines of force are stronger in the outer rim than in the central portion of base plate 33 in this manner, prevents the magnetic lines of force, which extend from sputtering target 16 towards wafer W from spreading out while moving away from sputtering target 16, the electrons can be effectively confined within the sputtering space, which is formed between sputtering target 16 and wafer W. Furthermore, the magnetic lines of force that extend from sputtering target 16 towards wafer W allow the electrons to leave the sputtering particles that are heading towards the side of wafer W to facilitate ionization of the sputtering particles. The ionized sputtering particles change their kinetic direction to head for sputtering target 16 by the affect of the electric field in between sputtering target 16 and shield 26, and then are accelerated, colliding with sputtering target 16. Sputtering target 16 is sputtered by the energy at the time of this collision, coming to be in the so-called state of self-sputtering.

Furthermore, by arranging six large diameter magnets 110N having a large magnetic force in a portion furthest from the central portion of sputtering target 16 on base plate 33, even in the case where base plate 33 is rotationally driven with rotating shaft 38 at its center, these six large diameter magnets 110N are in the state of always being positioned on the side of vacuum chamber 12 side wall. Accordingly, the magnetic lines of force that extend from the outer rim of sputtering target 16, which is on the side of vacuum chamber 12 side wall, to the side of wafer W, come to be in the state of extending towards the center of vacuum chamber 12 while proceeding to wafer W, and reduce the flow of electrons that flow out from shield 26, which is positioned on the side of vacuum chamber 12 side wall, contributing to improvements of confining ability of electrons.

Also, by arranging six large diameter magnets 110N having a large magnetic force in a portion furthest from the central portion of sputtering target 16 on base plate 33, generated plasma is extended to the side of the vacuum chamber 12 side wall, and as a result, the tendency of the eroded region to be concentrated in the central portion of sputtered target 16 can be controlled.

In addition, magnets are disposed in half of the region of sputtered target 16, making it possible to reduce the region of plasma formation in size by adjusting their positions. Electric force can be pumped into the shrunken region in this manner, thus the plasmatic density can be increased without increasing the pumped electrical force.

### Industrial Applicability

As described in detail above, in the sputtering apparatus according to the present invention, process gas is transformed into plasma in the vicinity of the erosion surface by the magnetic field of the magnetron unit. Due to this, target particles are sputtered from the erosion surface of the target. In addition, a magnetic field, where magnetic field components that run in the direction perpendicular to the erosion surface are greater than the magnetic field components that run in the horizontal direction, is generated by subunits in a different region than the vicinity of the erosion surface within the vacuum chamber. The sputtered particles are efficiently ionized in the region in the vacuum chamber where the vertical components of the magnetic field are dominant over the horizontal components. Due to this, the ionized particles are accelerated towards the erosion surface, and other sputtering particles generate when they collide with the erosion surface. Hence, self-sputtering successively occurs.

In other words, according to the sputtering apparatus of the present invention, a magnetic field, at which transformation of process gas into plasma, and ionization of sputtering particles can be performed spatially separated, can be formed. Also, the generation of a magnetic field appropriate for ionizing sputtering particles is possible without having much influence on the transformation of process gas into plasma. Due to this, process gas discharge can be generated with a relatively low voltage. In addition, during the transition into self-sputtering, this discharge can be prevented from being cut off.

Also, if film deposition is carried out using the sputtering apparatus of the present invention, particles generated through self-sputtering are successively accumulated on the surface of the substrate. Accordingly, a film with favorable bottom coverage is built up upon the substrate.

Accordingly, a sputtering apparatus that can generate a magnetic field appropriate for stably self-sputtering, and a film deposition method, which uses this sputtering apparatus is provided.

As a result, the present invention can contribute to improvements in performance of devices in the fabrication field of electronic microdevices, such as the semiconductor device.

## Claims

1. A sputtering apparatus, comprising
a vacuum chamber;
depressurizing means for depressurizing said chamber;
gas supplying means for supplying process gas into said vacuum chamber;
a substrate-supporting portion for supporting a substrate in said vacuum chamber;
a sputtering target disposed such that an erosion surface faces said substrate-supporting portion; and
a magnetron unit disposed on the opposite side of said erosion surface from said substrate-supporting portion, including a plurality of subunits;
wherein each of said plurality of subunits includes a first magnet part having a first magnet, said first magnet being disposed so that its one end indicating a first magnetic polarity faces said target; a second magnet part having a second magnet, said second magnet disposed so that its one end indicating a second magnetic polarity faces said target; and a first magnetic member for supporting said first and second magnets; and
wherein the magnetic charge of said first magnet part is greater than the magnetic charge of said second magnet part.

2. The sputtering apparatus according to Claim 1, wherein said first magnet part includes a third magnet disposed so that said third magnet is adjoined to said first magnet with the one end indicating said first magnetic polarity facing said target; and a second magnetic member for supporting said third magnet.

3. The sputtering apparatus according to Claim 1, wherein said sputtering target includes at least one of copper, palladium or gold.

4. The sputtering apparatus according to Claim 1, further comprising controlling means for reducing the amount of said process gas supplied after plasma is generated.

5. The sputtering apparatus according to Claim 1, further comprising controlling means for stopping the supply of said process gas during film deposition through sputtering.

6. The sputtering apparatus according to Claim 1, wherein said plurality of subunits are arranged along the direction that said erosion surface extends in said magnetron unit, and
wherein regarding a first and a second region, which are positioned in order along the axial from said erosion surface towards said substrate-supporting portion, said magnetron unit disposed to generate a magnetic field having magnetic field components running in the direction parallel to said erosion surface in said first region that are larger than the magnetic field components running in the direction perpendicular to said erosion surface, and to generate a magnetic field having magnetic field components running in the direction perpendicular to said erosion surface in said second region that are larger than the magnetic field components running in the direction parallel to said erosion surface.

7. A sputtering apparatus comprising:
a vacuum chamber;
depressurizing means for depressurizing said chamber;
gas supplying means for supplying process gas into said vacuum chamber;
a substrate-supporting portion for supporting a substrate in said vacuum chamber;
a sputtering target positioned so that the erosion surface faces said substrate-supporting portion; and
a magnetron unit disposed on the opposite side of said erosion surface from said substrate-supporting portion, including a plurality of subunits;
wherein each of said plurality of subunits includes a first magnet disposed so that its one end indicating a first magnetic polarity faces said target; a second magnet disposed so that its end indicating a second magnetic polarity faces said target; a first magnetic member for supporting said first and second magnets; a fourth magnet disposed so that said fourth magnet is adjoined to said first magnet, which has the one end indicating the first magnetic polarity facing said target; a fifth magnet disposed so that its one end indicating a second magnetic polarity faces said target; and a third magnetic member for supporting said fourth and fifth magnets.

8. The sputtering apparatus according to Claim 7, wherein said sputtering target includes at least one of copper, palladium or gold.

9. The sputtering apparatus according to Claim 7, further comprising controlling means for reducing the amount of said process gas supplied after plasma is generated.

10. The sputtering apparatus according to Claim 7, further comprising controlling means for stopping the supply of said process gas during film deposition through sputtering.

11. The sputtering apparatus according to Claim 7, wherein said plurality of subunits are arranged along the direction that said erosion surface extends in said magnetron unit; and
wherein regarding a first and a second region, which are positioned in order along the axial from said erosion surface towards said substrate-supporting portion, said magnetron unit is provided to generate a magnetic field having magnetic field components running in the direction parallel to said erosion surface in said first region that are larger than the magnetic field components running in the direction perpendicular to said erosion surface, and to generate a magnetic field having magnetic field components running in the direction perpendicular to said erosion surface in said second region that are larger than the magnetic field components running in the direction parallel to said erosion surface.

12. A sputtering apparatus comprising:
a vacuum chamber;
depressurizing means for depressurizing said chamber;
gas supplying means for supplying process gas into said vacuum chamber;
a substrate-supporting portion for supporting a substrate in said vacuum chamber;
a sputtering target provided so that the erosion surface faces said substrate-supporting portion; and
a magnetron unit disposed on the opposite side of said erosion surface from said substrate-supporting portion, including a plurality of subunits;
wherein each of said plurality of subunits includes a sixth magnet having its one end indicating a first magnetic polarity and the other end indicating a second magnetic polarity, disposed so that said one end faces said target; a seventh magnet disposed so that its one end indicating said second magnetic polarity faces said target; a fourth magnetic member for supporting said sixth and seventh magnets; and a fifth magnetic member that magnetically bonds said one end and said other end of said sixth magnet.

13. The sputtering apparatus according to Claim 12, wherein said sputtering target includes at least one of copper, palladium or gold.

14. The sputtering apparatus according to Claim 12, further comprising controlling means for reducing the amount of said process gas supplied after plasma is generated.

15. The sputtering apparatus according to Claim 12, further comprising controlling means for stopping the supply of said process gas during film deposition through sputtering.

16. The sputtering apparatus according to Claim 12, wherein said plurality of subunits are disposed along the direction that said erosion surface extends in said magnetron unit, and
wherein regarding a first and a second region, which are positioned in order along the axial from said erosion surface towards said substrate-supporting portion, said magnetron unit is disposed to generate a magnetic field having magnetic field components running in the direction parallel to said erosion surface in said first region that are larger than the magnetic field components running in the direction perpendicular to said erosion surface, and to generate a magnetic field having magnetic field components running in the direction perpendicular to said erosion surface in said second region that are larger than the magnetic field components running in the direction parallel to said erosion surface.

17. A sputtering apparatus comprising:
a sputtering target disposed within a chamber;
depressurizing means for depressurizing said chamber;
gas supplying means for supplying process gas into said chamber;
plasma generating means for transforming process gas supplied into said chamber into a plasma state by applying voltage to said sputtering target; and
magnetron unit arranged along said sputtering target;
wherein said magnetron unit includes first magnet parts having a first polarity, said first magnet parts being annularly arranged; second magnet parts having a second polarity differing from said first polarity and a gross magnetic charge greater than the gross magnetic charge of said first magnet parts, said second magnet parts being annularly arranged so as to surround said first magnet parts; and said gas supplying means for reducing the amount of process gas supplied into said chamber after said process gas is transformed into a plasma state.

18. A film deposition method using a sputtering apparatus, in which said sputtering apparatus comprises:
a sputtering target disposed in a chamber;
depressurizing means for depressurizing said chamber;
gas supplying means for supplying process gas into said chamber;
plasma generating means for transforming process gas supplied into said chamber into a plasma state by applying voltage to said sputtering target; and
a magnetron unit arranged along said sputtering target; and
said magnetron unit including,
first magnet parts having a first polarity, said first magnet parts being annularly arranged, and
second magnet parts having a second polarity differing from said first polarity and a gross magnetic charge greater than the gross magnetic charge of said first magnet parts, said second magnet parts being annularly arranged so as to surround said first magnet parts,
said film deposition method comprising:
a first step of supplying said process gas into said chamber under a reduced pressure, transforming said process gas into the plasma state, and scattering sputtering particles from said sputtering target; and
a second step of reducing the amount of process gas supplied into said chamber after said process gas is transformed into the plasma state through said first step.
